# EUROPEAN PATENT SPECIFICATION

(11) **EP 4 020 512 B1**
(45) Date of publication and mention of the grant of the patent: **16.09.2026**
(21) Application number: 20873347.7
(22) Date of filing: 17.12.2020
(51) Int. Cl.: H01H 11/04, C23C 14/35, C23C 14/16

(54) **PREPARATION METHOD FOR SILVER METAL OXIDE SHEET-LIKE ELECTRICAL CONTACT**
VERFAHREN ZUR HERSTELLUNG VON ELEKTRISCHEN KONTAKTSPITZEN AUS SILBER-METALLOXID
PROCÉDÉ DE PRÉPARATION DE CONTACT ÉLECTRIQUE DE TYPE FEUILLE D'OXYDE MÉTALLIQUE D'ARGENT

(30) Priority: 11.11.2020 CN 202011254614
(43) Date of publication of application: 29.06.2022
(73) Proprietor: Zhejiang Fuda Alloy Materials Technology Co., Ltd., Wenzhou City, Zhejiang Province (CN)
(72) Inventor: WAN, Dai, Zhejiang 325025 (CN); SONG, Zhenyang, Zhejiang 325025 (CN); MIAO, Renliang, Zhejiang 325025 (CN); ZHEN, Zecheng, Zhejiang 325025 (CN); ZHANG, Mingjiang, Zhejiang 325025 (CN); LIU, Yingfei, Zhejiang 325025 (CN); WEI, Qinghong, Zhejiang 325025 (CN); XIA, Zongbin, Zhejiang 325025 (CN); CHEN, Kaisong, Zhejiang 325025 (CN); SONG, Linyun, Zhejiang 325025 (CN); WANG, Dawu, Zhejiang 325025 (CN)
(74) Representative: Herzog IP Patentanwalts GmbH
(86) International application number: PCT/CN2020/137148
(87) International publication number: WO 2022/099854

(56) References cited:
- EP-A2- 1 096 523
- CN-A- 105 225 855
- CN-A- 105 428 097
- CN-A- 106 854 710
- CN-A- 107 557 733
- CN-A- 108 468 030
- CN-A- 108 468 030
- CN-A- 111 020 268
- DE-C1- 10 214 973
- JP-A- 2008 152 971
- JP-A- H03 203 133
- JP-A- S5 444 760
- JP-A- S6 033 325

## Description

### FIELD OF THE INVENTION

The present disclosure relates to the field of electrical engineering alloy materials, in particular to a method for preparing electrical contact tips of silver metal oxide applied to contactor, circuit breaker, relay and the like.

### BACKGROUND OF THE INVENTION

In the low-voltage electrical appliance industry, the most widely used electrical contact materials are silver based electrical contact materials, wherein silver metal oxide electrical contact materials play an important role in the entire electrical contact materials system due to its excellent anti-arc erosion property, resistance to welding, and low and stable contact resistance, etc. When silver metal oxide materials are used in the field of contactors with higher current levels, they are usually processed to contact tips and brazed onto the copper alloy contact bridge. Due to the poor wettability between silver metal oxide material and both solder and copper alloy contact bridge, it is necessary to form a pure silver layer on the welding surface as a transition layer during contact manufacturing process, so as to improve the brazing strength and brazing area between the contact and the contact bridge. According to the processing and application process, and considering the cost factor, the requirements for the pure silver layer can be divided into three aspects.
(1) High and stable bonding strength, and there is no interface peeling phenomenon during the process of brazing and electrical contacting.
(2) The thickness of the pure silver layer is uniform and controllable, and as thin as possible on the premise of meeting the standards, welding requirements and application requirements.
(3) The welding surface of the silver layer has good flatness and wettability to ensure that the contact has enough brazing strength and brazing area in the brazing process.

At present, there are four kinds of pure silver layer forming process in the industry, which are powder hot pressing process, hot rolling process, extruding process and cold heading process. The fluctuation range of the silver layer in these processes is about 5%~20% of the thickness of the contact. In addition, the advantages and disadvantages of the above four processes are as follows.

| Process | Advantages | Disadvantages |
|---|---|---|
| Powder hot pressing process | 1. The contact area between working layer and silver layer is large and the bonding strength is excellent; and | 1. This process has a narrow scope of application and is only suitable for materials of powder metallurgy process; |
| | | 2. The thickness of silver layer is thick, and the distribution of silver layer is uneven, and cost of material is high; and |
| | 2. High material utilization and low manufacturing cost. | |
| | | 3. The phenomenon that the working layer powder and silver layer are cross contaminated with each other is easily occurred during the process. |
| Hot rolling process and extruding process | 1. These processes belong to thermal diffusion cladding, and the products have very high bonding strength; | 1. The requirement of interface cleanliness before cladding is very high, and the influence of local impurities and foreign matters on the surface of the material to be cladded have a serious impact on the bonding strength; |
| | 2. The thickness distribution of the silver cladding layer is relatively uniform and the thickness of the silver cladding layer is controllable; and | |
| | | 2.The round contact, special-shaped contact and part of square contact can only be processed by punching and blanking after the strip is cladded with silver, thus the material utilization rate is low and the manufacturing cost is high; and |
| | 3.These processes can be used to prepare contact tips of most specifications. | |
| | | 3. Flatness of the welding surface is poor by punching, which affects the welding quality. |
| Cold heading process | 1. High material utilization and low manufacturing cost; | 1. This process is a kind of cold cladding, and the bonding strength is poor; |
| | 2. The cladding process belongs to the cold pressure welding forming of the fracture position of the wire feeding section, and the influence factors of the bonding strength are less; and | 2. This process requires a sufficient thickness of the silver layer to complete the cold heading process; the uniformity of the silver layer distribution is poor, and the silver content in the contact is relatively higher than that of the same material and specifications; |
| | | 3. Compared with the contact tips prepared by the process of hot cladding, the silver layer is thicker and the working layer is thinner, and theoretically the electrical endurance of the contact material will be reduced to a certain extent; |
| | 3. The flatness of the welding surface is good, which is conducive to braze. | |
| | | 4. There are certain restrictions on the specifications that can be processed, not all specifications can adopt this production process, and it is only suitable for the production of round or square with round corners contacts, and contacts that are too thin cannot be produced by this process; and |
| | | 5. This process requires high plasticity of the material, and the material with poor plasticity is prone to crack in this process. |

Therefore, the development of a new silver layer forming process, which combining the respective advantages of the above mentioned silver layer forming processes, avoiding the disadvantages of the above mentioned processes to a certain extent, ensuring the bonding strength of the working layer and the welding silver layer and improving the material utilization rate, has significant practical application value. The patent ZL 201010190479.1 discloses a method for preparing pure silver layer of contact by screen printing. In this method, the silver paste is coated on the surface of the contact by covering the contact with a screen mold, then the contact is sintered in a sintering furnace to sinter the silver paste on the surface of the contact to prepare contact tip with pure silver layer. This preparation method has advantages of high material utilization rate and good consistency of silver layer, however, in order to ensure the fluidity of silver paste, a certain amount of organic substance must be added. And the preparation method has special requirements for the particle size distribution and morphology of raw material silver powder, and the manufacture cost for preparing silver paste itself is high. After sintering, defects such as holes are prone to appear in the silver layer, which affects the brazing performance of the contact. Due to the fluidity of silver paste, the minimum thickness of silver layer is limited. The patent 94193439.X discloses a preparation process of silver metal oxide contact material connection layer based on single-side reduction method. In this process, silver alloy layer after reduction treatment is used as the connection layer. After practice, it is difficult to obtain a uniform connection layer distribution by this method. Under the condition of no pressure, the diffusion of reducing atmosphere in silver metal oxide material is not synchronous, and there is a phenomenon that the local diffusion rate is uneven, which makes poor distribution uniformity of the prepared contact silver layer. After reduction treatment, the structure of silver alloy layer is loose, and the gas is easily sealed during the brazing process, resulting in low shear strength after brazing.

DE10214973C1 discloses a contact layer system consisting of three individual layers on a substrate and two methods for producing the contact layer system. The transition regions between the monolayers exhibit a continuous or gradual transition from the metal or metal alloy of a monolayer to the different metal or metal alloy of an adjacent monolayer. With the contact layer system according to the invention, high switching loads can be realized without cracking occurring.

### SUMMARY OF THE INVENTION

In order to solve the above problems in the prior art, the present disclosure provides a method for preparing electrical contact tips of silver metal oxide, which combines the respective advantages of several conventional preparation processes, avoids the disadvantages of the above processes to a certain extent, improves the distribution uniformity of the silver layer under the premise of ensuring the bonding strength of the working layer and the welding silver layer, and reduces the cost of contact in switching apparatus.

The technical solution of the present disclosure is as follows.

The present disclosure provides a method for preparing electrical contact tips of silver metal oxide. In this method, silver is plated on AgMeO substrate by magnetron sputtering process. The thickness of silver plating layer is 0.01 *mm~0.20 mm* and the distribution uniformity of the silver layer is ±0.005 *mm.* During silver plating by magnetron sputtering process, the AgMeO substrate is heated and kept at 30%-65% of the melting point of the AgMeO substrate. The AgMeO is one of silver tin oxide, silver copper oxide, silver zinc oxide, silver tin oxide indium oxide, silver cadmium oxide or silver iron oxide.

Wherein, when the AgMeO substrate is round or quadrate, the method comprises following steps:
① preparing AgMeO wire: preparing AgMeO wire by conventional internal oxidation process, pre-oxidation process or powder metallurgy process, etc., and processing the AgMeO wire by drawing and annealing to required specification and state;
② forming by cold heading: the AgMeO wire is processed to AgMeO tip blank by cold heading equipment, and welding surface of the AgMeO tip blank is marked with pattern during forming by cold heading;
③ surface treatment: the AgMeO tip blank is cleaned by ultrasonic cleaning equipment to remove oil, and then the AgMeO tip blank with clean surface and without organic residue is obtained;
④ plating silver by magnetron sputtering: placing the AgMeO tip blank in a tray with pattern side upward, placing the tray in a magnetron sputtering equipment, installing a fine silver target, pre-vacuumizing plating chamber to ≤5×10⁻⁴ *Pa* after closing the plating chamber, turning off vacuum pump and exhaust valve of the plating chamber after vacuum degree of the plating chamber reaches the required value, filling the plating chamber with high-purity argon gas, and turning on a DC power supply to deposit fine silver material on the pattern side of the AgMeO tip blank by sputtering process, wherein bias current is 0.01~0.10 *A*, bias voltage is 10~100 *V*, and time is 1~30 *h;* and
⑤ spot inspection and packaging: rejecting the products with poor appearance and size by visual sorting equipment, packaging the qualified products and pasting with labels automatically to obtain finished contacts of AgMeO/Ag.

Wherein, when the AgMeO substrate is square or rectangular, the method comprises the following steps:
① preparing AgMeO strip: preparing AgMeO strip by conventional internal oxidation process, pre-oxidation process or powder metallurgy process, etc., rolling the AgMeO strip to a thickness of semi-finished products, and removing impurities and oil stains on a surface of the AgMeO strip by surface treatment;
② plating silver by magnetron sputtering: winding the AgMeO strip on a barrel of a magnetron sputtering equipment tightly, loading the barrel into the magnetron sputtering equipment for silver plating, installing a fine silver target, pre-vacuumizing plating chamber to ≤5×10⁻⁴ *Pa* after closing the plating chamber, turning off vacuum pump and exhaust valve of the plating chamber after the vacuum degree of the plating chamber reaches the required value, filling the plating chamber with high-purity argon gas, and turning on a DC power supply to deposit fine silver material on an external surface of the AgMeO strip by sputtering process to obtain AgMeO/Ag strip, wherein bias current is 0.01~0.10 *A*, bias voltage is 10~100 *V*, and time is 1~30 *h;* and
③ slitting the AgMeO/Ag strip to a width of semi-finished products, and processing the AgMeO/Ag strip to a width, thickness and shape of finished products by profile rolling; at the same time, pattern mark is rolled on a surface of silver plating layer during profile rolling; then AgMeO/Ag electrical contact semi-finished tips are obtained by cutting and blanking according to a length requirement of the finished products; after surface treatment of the AgMeO/Ag electrical contact semi-finished tips, rejecting products with poor appearance and size by visual sorting equipment, packaging qualified products and pasting with labels automatically to obtain finished contacts of AgMeO/Ag.

Wherein, when the shape of the AgMeO substrate is irregular, the method comprises the following steps:
① preparing AgMeO strip: preparing AgMeO strip by conventional internal oxidation process, pre-oxidation process or powder metallurgy process, etc., rolling the AgMeO strip to a thickness of semi-finished products, and removing impurities and oil stains on a surface of the AgMeO strip by surface treatment;
② plating silver by magnetron sputtering: winding the AgMeO strip on a barrel of a magnetron sputtering equipment tightly, loading the barrel into the magnetron sputtering equipment for plating silver, installing a fine silver target, pre-vacuumizing plating chamber to ≤5×10⁻⁴ *Pa* after closing the plating chamber, turning off vacuum pump and exhaust valve of the plating chamber after vacuum degree of the plating chamber reaches the required value, filling the plating chamber with high-purity argon gas, and turning on a DC power supply to deposit fine silver material on an external surface of the AgMeO strip by sputtering process to obtain AgMeO/Ag strip, wherein bias current is 0.01~0.10 *A*, bias voltage is 10~100 *V*, and time is 1~30 *h;* and
③ preparing AgMeO/Ag electrical contact semi-finished tips using the AgMeO/Ag strip in a manner of punching and blanking, and stamping pattern mark on a surface of silver plating layer during punching process; and after a surface treatment of the AgMeO/Ag electrical contact semi-finished tips, rejecting products with poor appearance and size by visual sorting equipment, packaging qualified products and pasting with labels automatically to obtain finished contacts of AgMeO/Ag.

Wherein, during plating silver by magnetron sputtering process, the AgMeO substrate is heated and kept at a temperature of 300-600°C.

Preferably, during silver plating by magnetron sputtering process,
when the AgMeO substrate is silver tin oxide, the silver tin oxide substrate is heated and kept at a temperature of 350~450°C;
when the AgMeO substrate is silver copper oxide, the silver copper oxide substrate is heated and kept at a temperature of 300~420°C;
when the AgMeO substrate is silver zinc oxide, the silver zinc oxide substrate is heated and kept at a temperature of 320~460°C;
when the AgMeO substrate is silver iron oxide, the silver iron oxide substrate is heated and kept at a temperature of 300~450°C;
when the AgMeO substrate is silver cadmium oxide, the silver cadmium oxide substrate is heated and kept at a temperature of 300~400°C; and
when the AgMeO substrate is silver tin oxide indium oxide, the silver tin oxide indium oxide substrate is heated and kept at a temperature of 320~480°C.

Preferably, parameters of the magnetron sputtering process are as follows: sputtering power is 500~1500 *W,* sputtering gas pressure is 3.5~4.5 *mTorr,* gas flow of Ar is 25~35 *sccm,* and distance between the target and the substrate is 6 ~ 15 *cm.*

The present disclosure has the following beneficial effects.
1. The silver saving effect is obvious during the application of contact. Due to the poor wettability between silver metal oxide material and both solder and contact bridge material, the electrical contact tips prepared by the silver metal oxide material cannot be brazed directly, so a fine silver layer should be added as a welding silver layer. The main function of the welding silver layer is to ensure the brazing strength. In the national standard, the thickness of the welding silver layer of silver metal oxide electrical contact tips is usually 10%~20% of the total thickness of the contact, and the silver metal oxide layer with the remaining thickness guarantees the electrical contact performance. Therefore, for the electrical contact process, the thickness of the welding silver layer only needs to ensure that there is enough brazing strength after brazing, and the excess thickness of silver layer is a waste of cost. For the conventional processes of powder hot pressing process, hot rolling process, extruding process and cold heading process, due to the limitation of these technological means, there are varying degrees of fluctuations in the silver layer thickness, and the fluctuation range is usually between 5% and 20%, so the minimum value of silver layer that can be prepared is limited. The present disclosure prepares silver plating layer of contact tip by magnetron sputtering process, and the thickness of silver plating layer is controlled by silver plating time. The thickness range of silver plating layer can be prepared is 0.01~0.20 *mm,* and fluctuation range of the thickness of silver plating layer can be controlled within ±0.005 *mm.* On the premise of meeting the requirements of brazing strength, a welding silver layer with a thinner thickness can be prepared by the method disclosed in the present disclosure. Compared with the traditional preparation process, on the premise of preparing a same thickness of the silver metal oxide layer, the extra thickness of welding silver layer can be saved, the cost of the contact material in the switching apparatus can be significantly reduced, and the precious metal resources can be saved.
2. In the present disclosure, during silver plating by magnetron sputtering process, the AgMeO substrate is heated and kept at 60%-80% of the melting point of the AgMeO substrate. The results of research and experiment show that in this process, there are multiple advantages when plating silver on the AgMeO substrate by magnetron sputtering process. At first, the activity of atoms and molecules of the AgMeO substrate can be activated in this process. When the silver atoms sputtered from the target contact with the AgMeO substrate, the active particles of AgMeO substrate can receive, clamp or even wrap the silver atoms, so that the silver atoms are closely combined with the AgMeO substrate to form an embedding structure, thus increasing the grip of the deposited silver plating layer, which makes the formed silver plating layer combined with the substrate firmly. Since the silver plating layer of the present disclosure is used for subsequent brazing, it objectively requires a thicker silver plating layer compared with the ordinary plating layer. A thicker plating layer is easy to fall off. Therefore, during the magnetron sputtering process, heating and heat preservation applied to the substrate can promote the formation of a more solid and stable silver plating layer. At this temperature, the crystal size of the silver plating layer should be appropriate. If the size of crystal particle is too small, there will be more grain boundary scattering, resulting a decrease of resistivity. If the size of crystal particle is too large, not only the defects of the silver plating layer will increase, but also the resistivity will increase. Therefore, the temperature of AgMeO substrate maintained in the present disclosure can promote the bonding strength between the silver plating layer and the substrate, at the same time, it can also promote the crystal particle of the silver plating layer to have an appropriate size, thus the silver plating layer has an excellent performance and making the silver plating player as thin as possible. Further, keeping the AgMeO substrate at the temperature can avoid being magnetized under the action of magnetic field and avoid absorbing too many electrons, resulting in instability of the silver plating layer, and at the same time, avoid the interference of magnetized substrate to external magnetic field.
3. The present disclosure proposes different heating ranges for the substrates of silver tin oxide, silver copper oxide, silver zinc oxide, silver tin oxide indium oxide, silver cadmium oxide or silver iron oxide respectively when plating silver by magnetron sputtering process, and proposes a method for preparing electrical contact plated with silver by magnetron sputtering process according to the shape of substrate. The prepared electrical contact has good and stable mechanical strength and electrical property. The yield of finished products is high, the process is stable, and it is suitable for mass production.
4. Powder hot pressing process has the highest material utilization ratio among all mass production processes. However, due to the low density and poor arc burning resistance of the working layer of contact prepared by this process, the powder hot pressing process has been gradually replaced by extruding process. In the conventional production processes, the punching and blanking method is adopted, and the material utilization ratio is only 40%-60% in punching process, which seriously reduces the whole material utilization ratio, so the punching process must be replaced by other forming methods. The process to prepare contact tip by cold heading is a relatively mature process in the existing manufacturing process. The material utilization ratio of cold heading process is slightly lower than powder hot pressing process, but higher than extruding-punching process. When preparing AgMeO contact tips by traditional cold heading process, the main defects are poor bonding strength and uneven distribution of silver layer. Based on the above factors, the following process route is designed: working layer adopts cold heading process to make single-layer contact, and then uses magnetron sputtering plating equipment plating silver on the welding surface of the contact tip prepared by cold heading process. In this way, not only the overall material utilization rate can be ensured, but also the purposes of controlling the thickness and distribution uniformity of silver layer can be achieved.

### BRIEF DESCRIPTION OF THE DRAWINGS

In order to more clearly illustrate the embodiments of the present disclosure or the technical solutions in the prior art, the following will briefly introduce the drawings that need to be used in the description of the embodiments or the prior art. It is obvious that the drawings in the following description are only some embodiments of the present disclosure. For a person skilled in the art, on the premise of not paying creative labor, the drawings and other drawings obtained according to these drawings are still within the scope of the present disclosure.
Figure 1 is an integral metallographic picture of finished contacts of AgMeO/Ag electrical contact tip in the present disclosure.
Figure 2 is a partial metallographic picture at 200 times of the finished contacts of AgMeO/Ag electrical contact tip in the present disclosure.
Figure 3 is a partial metallographic picture at 500 times of the finished contacts of AgMeO/Ag electrical contact tip in the present disclosure.

### DETAILED DESCRIPTION OF THE INVENTION

The present disclosure will be described in detail in combination with the drawings and specific embodiments.

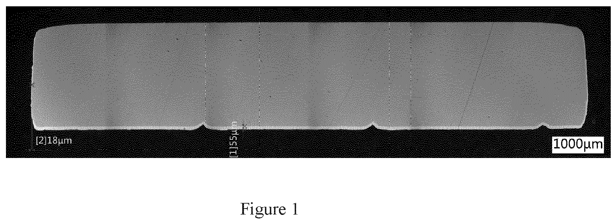

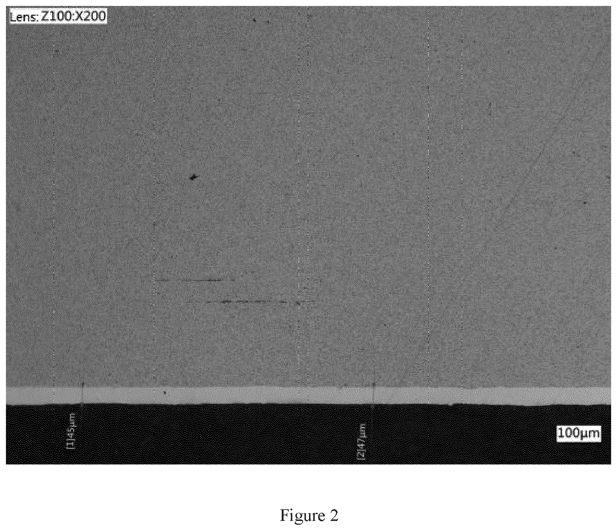

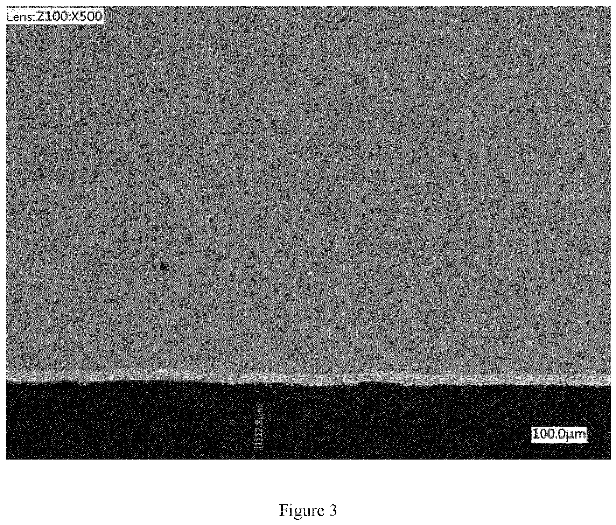

Referring to figures 1 to 3, a method for preparing electrical contact tips of silver metal oxide is described. In this method, silver is plated on the AgMeO substrate by magnetron sputtering process. Thickness of the silver plating layer is 0.01 *mm~0.20 mm* and distribution uniformity of the silver layer is ±0.005 *mm.* During silver plating by magnetron sputtering process, the AgMeO substrate is heated and kept at 30%-65% of the melting point of the AgMeO substrate.

Further, when the AgMeO substrate is round or quadrate, the preparation method comprises the following steps.
① Preparing AgMeO wire: preparing AgMeO wire by conventional internal oxidation process, pre-oxidation process or powder metallurgy process, etc., and processing the AgMeO wire by drawing and annealing to the required specification and state.
② Forming by cold heading: the AgMeO wire is processed to AgMeO tip blank by cold heading equipment, and the welding surface of the AgMeO tip blank is marked with pattern during forming by cold heading.
③ Surface treatment: the AgMeO tip blank is cleaned by ultrasonic cleaning equipment to remove oil, and then the AgMeO tip blank with clean surface and no organic residue is obtained.
④ Plating silver by magnetron sputtering: placing the AgMeO tip blank in the tray with the pattern side upward, placing the tray in the magnetron sputtering equipment, installing the fine silver target, pre-vacuumizing the plating chamber to ≤5×10⁻⁴ *Pa* after closing the plating chamber, turning off the vacuum pump and the exhaust valve of the plating chamber after the vacuum degree reaches the required value, filling the plating chamber with high-purity argon gas, and turning on the DC power supply to deposit the fine silver material on the pattern side of the AgMeO tip blank by sputtering process, wherein bias current is 0.01~0.10 *A*, bias voltage is 10~100 *V*, and time is 1~30 *h.*
⑤ Spot inspection and packaging: rejecting the products with poor appearance and size by visual sorting equipment, packaging the qualified products and pasting with labels automatically to obtain finished contacts of AgMeO/Ag.

Further, when the AgMeO substrate is square or rectangular, the preparation method comprises the following steps.
①Preparing AgMeO strip: preparing AgMeO strip by conventional internal oxidation process, pre-oxidation process or powder metallurgy process, etc., rolling the AgMeO strip to the thickness of semi-finished products, and removing the impurities and oil stains on the surface of the AgMeO strip by surface treatment.
② Plating silver by magnetron sputtering: winding the AgMeO strip on the barrel of the magnetron sputtering equipment tightly, loading the barrel into the magnetron sputtering equipment for silver plating, installing the fine silver target, pre-vacuumizing the plating chamber to ≤5×10⁻⁴ *Pa* after closing the plating chamber, turning off the vacuum pump and the exhaust valve of the plating chamber after the vacuum degree reaches the required value, filling the plating chamber with high-purity argon gas, and turning on the DC power supply to deposit the fine silver material on the external surface of the AgMeO strip by sputtering process to obtain AgMeO/Ag strip, wherein bias current is 0.01~0.10 *A*, bias voltage is 10~100 *V*, and time is 1~30 *h.*
③ Slitting the AgMeO/Ag strip to the width of semi-finished products, and processing the AgMeO/Ag strip to the width, thickness and shape of the finished products by profile rolling. At the same time, pattern mark is rolled on the surface of the silver plating layer during profile rolling. Then the AgMeO/Ag electrical contact semi-finished tips are obtained by cutting and blanking according to the length requirements of the finished products. After the surface treatment of the AgMeO/Ag electrical contact semi-finished tips, rejecting the products with poor appearance and size by visual sorting equipment, packaging the qualified products and pasting with labels automatically to obtain finished contacts of AgMeO/Ag.

Further, when the shape of the AgMeO substrate is irregular, the preparation method comprises the following steps.
① Preparing AgMeO strip: preparing AgMeO strip by conventional internal oxidation process, pre-oxidation process or powder metallurgy process, etc., rolling the AgMeO strip to the thickness of semi-finished products, and removing the impurities and oil stains on the surface of the AgMeO strip by surface treatment.
② Plating silver by magnetron sputtering: winding the AgMeO strip on the barrel of the magnetron sputtering equipment tightly, loading the barrel into the magnetron sputtering equipment for plating silver, installing the fine silver target, pre-vacuumizing the plating chamber to ≤5×10⁻⁴ *Pa* after closing the plating chamber, turning off the vacuum pump and the exhaust valve of the plating chamber after the vacuum degree reaches the required value, filling the plating chamber with high-purity argon gas, and turning on the DC power supply to deposit the fine silver material on the external surface of the AgMeO strip by sputtering process to obtain AgMeO/Ag strip, wherein bias current is 0.01~0.10 *A*, bias voltage is 10~100 *V*, and time is 1~30 *h.*
③ Preparing AgMeO/Ag electrical contact semi-finished tips using the AgMeO/Ag strip in the manner of punching and blanking, and stamping the pattern mark on the surface of silver plating layer during punching process. After the surface treatment of the AgMeO/Ag electrical contact semi-finished tips, rejecting the products with poor appearance and size by visual sorting equipment, packaging the qualified products and pasting with labels automatically to obtain finished contacts of AgMeO/Ag.

Further, the parameters of the magnetron sputtering process are as follows. Sputtering power is 500~1500 *W,* sputtering gas pressure is 3.5~4.5 *mTorr,* gas flow of Ar is 25~35 *sccm,* and distance between target and substrate is 6~15 *cm.*

The AgMeO substrate used in the present disclosure is one of silver tin oxide, silver copper oxide, silver zinc oxide, silver tin oxide indium oxide, silver cadmium oxide or silver iron oxide.

During silver plating by magnetron sputtering process, the AgMeO substrate is heated and kept at the temperature of 300-600°C.

Futher,
when the AgMeO substrate is silver tin oxide, the silver tin oxide substrate is heated and kept at the temperature of 350~450°C;
when the AgMeO substrate is silver copper oxide, the silver copper oxide substrate is heated and kept at the temperature of 300~420°C;
when the AgMeO substrate is silver zinc oxide, the silver zinc oxide substrate is heated and kept at the temperature of 320~460°C;
when the AgMeO substrate is silver iron oxide, the silver iron oxide substrate is heated and kept at the temperature of 300~450°C;
when the AgMeO substrate is silver cadmium oxide, the silver cadmium oxide substrate is heated and kept at the temperature of 300~400°C; and
when the AgMeO substrate is silver tin oxide indium oxide, the silver tin oxide indium oxide substrate is heated and kept at the temperature of 320~480°C.

The specific embodiments of the corresponding methods for preparing electrical contact tips are as follows.

Example 1, the AgMeO substrate is silver tin oxide indium oxide.
a) 22 *kg* silver, 2 *kg* tin and 1 *kg* indium are melted in graphite crucible of medium frequency melting furnace to form molten liquid of silver-tin-indium alloy. Silver-tin-indium alloy powder is prepared using the molten liquid of silver-tin-indium alloy by high pressure water atomization equipment. Silver tin oxide indium oxide powder with 85% silver content is prepared after drying, sieving and oxidizing of silver-tin-indium alloy powder.
b) The silver tin oxide indium oxide powder is pressed to ingots with a size of φ105 *mm* by cold isostatic pressing equipment. After sintering at 850°C for 4 hours, the ingots are extruded to a strip with a size of 50×4 *mm* and then the strip is rolled to a size of 50×2.25 *mm.* After surface treatment, the impurities and oil stains on the surface of the strip are removed, and the silver tin oxide indium oxide semi-finished strip is obtained.
c) The silver tin oxide indium oxide semi-finished strip is winded on the barrel of the magnetron sputtering equipment tightly, loading the barrel into the magnetron sputtering equipment using for silver plating, installing the fine silver target, and pre-vacuumizing the plating chamber to ≤5×10⁻⁴ *Pa* after closing the plating chamber. At the same time, turning on the resistive heater to heat the silver tin oxide indium oxide semi-finished strip to 350°C. After the vacuum degree reaches the required value, turning off the vacuum pump and the exhaust valve of the plating chamber, filling the plating chamber with high-purity argon gas, and turning on the DC power supply for 25 *h* to deposit the fine silver material on the external surface of the silver tin oxide indium oxide semi-finished strip by sputtering process to obtain silver tin oxide indium oxide/silver strip. The thickness of the silver plating layer is 0.25 *mm.*
d) Slitting the silver tin oxide indium oxide/silver strip to a size of 11.5×2.5 *mm* and processing it to a size of 12×2.0 *mm* by profile rolling. During profile rolling, rolling the pattern mark on the surface of silver plating layer. Cutting and blanking the strip according to a length of *16 mm* to obtain the silver tin oxide indium oxide/silver electrical contact semi-finished tips. After the surface treatment of the silver tin oxide indium oxide/silver electrical contact semi-finished tips, rejecting the products with poor appearance and size by visual sorting equipment, packaging the qualified products and pasting with labels automatically to obtain silver tin oxide indium oxide/silver finished contacts. Specification of the contacts is 16×12×2 *mm,* the thickness of silver plating layer is 0.20 *mm,* the distribution range of the silver plating layer is ±0.005 *mm,* and bonding strength of the silver plating layer is ≥100 *N*/*mm²* after brazing.

According to the shape of the above silver tin oxide indium oxide/silver substrate, there are different preparation routes.
Route 1: Atomizing → powder oxidation → isostatic pressing → sintering → extruding → rolling → surface treatment → plating silver by magnetron sputtering → punching → surface treatment → spot inspection and packaging.
Route 2: Atomizing → powder oxidation → isostatic pressing → sintering → extruding → rolling → surface treatment → plating silver by magnetron sputtering → slitting → profile rolling → cutting → surface treatment → spot inspection and packaging.

Example 2, the AgMeO substrate is silver tin oxide.
a) 19.5 *kg* silver powder, 2.73 *kg* tin oxide powder and 0.5 *kg* additive powder are mixed in plough shovel mixer for 4 *h* to prepare silver tin oxide powder with 88% silver content, wherein, the silver powder is -200 *mesh,* the average particle size of tin oxide powder is 5 *µm,* and the average particle size of additive powder is *2 µm.*
b) The silver tin oxide powder is pressed to ingots with a size of φ88 *mm* by cold isostatic pressing equipment. After sintering at 900°C for 6 hours, the ingots are extruded to a strip with a size of 40×4 *mm* and then the strip is rolled to a size of 40×2.45 *mm.* After surface treatment, the impurities and oil stains on the surface of the strip are removed, and the silver tin oxide semi-finished strip is obtained.
c) Winding the silver tin oxide semi-finished strip on the barrel of the magnetron sputtering equipment tightly, loading the barrel into the magnetron sputtering equipment for silver plating, installing the fine silver target, and pre-vacuumizing the plating chamber to ≤5×10⁻⁴ *Pa* after closing the plating chamber. At the same time, turning on the resistive heater to heat the silver tin oxide semi-finished strip to 380°C. After the vacuum degree reaches the required value, turning off the vacuum pump and the exhaust valve of the plating chamber, filling the plating chamber with high-purity argon gas, and turning on the DC power supply for 5 *h* to deposit the fine silver material on the external surface of the silver tin oxide semi-finished strip by sputtering process to obtain silver tin oxide/silver strip. The thickness of the silver plating layer is 0.05 *mm.*
d) Preparing silver tin oxide/silver electrical contact semi-finished tips using the silver tin oxide/silver strip in the manner of punching and blanking, and stamping the pattern mark on the surface of silver plating layer during punching process. After the surface treatment of the silver tin oxide/silver electrical contact semi-finished tips, rejecting the products with poor appearance and size by visual sorting equipment, packaging the qualified products and pasting with labels automatically to obtain silver tin oxide/silver finished contacts. Specification of the contacts is φ20×2.5 *mm,* the thickness of silver plating layer is 0.05 *mm,* the distribution range of the silver plating layer is ±0.005 *mm,* and the bonding strength of the silver plating layer is ≥100 *N*/*mm²* after brazing.

According to the shape of the above silver tin oxide/silver substrate, there are different preparation routes.
Route 1: Preparing powder → mixing powder → isostatic pressing → sintering → extruding → rolling → surface treatment → plating silver by magnetron sputtering → punching → surface treatment → spot inspection and packaging.
Route 2: Preparing powder → mixing powder → isostatic pressing → sintering → extruding → rolling → surface treatment → plating silver by magnetron sputtering → slitting → profile rolling → cutting → surface treatment → spot inspection and packaging.

Example 3, the AgMeO substrate is silver cadmium oxide.
a) 21.350 *kg* silver, 3.375 *kg* cadmium and 0.275 *kg* additive are melted in graphite crucible of medium frequency melting furnace, then casting the molten liquid to form silver-cadmium alloy ingots with a size of φ90 *mm,* and after turning, the clean silver-cadmium alloy ingots with a size of φ88 *mm* are obtained.
b) Heating the silver-cadmium alloy ingots to 750°C in medium frequency heating equipment, extruding them to a strip with a size of 60×5 *mm,* and rolling it to a size of 60×0.85 *mm* to obtain silver-cadmium alloy semi-finished strip. After internal oxidation treatment of the silver-cadmium alloy semi-finished strip, the silver cadmium oxide strip with 85% silver content is obtained. After removing the impurities and oil stains of the strip by surface treatment, silver cadmium oxide semi-finished strip is obtained.
c) Winding the silver cadmium oxide semi-finished strip on the barrel of the magnetron sputtering equipment tightly, loading the barrel into the magnetron sputtering equipment for silver plating, installing the fine silver target, and pre-vacuumizing the plating chamber to ≤5×10⁻⁴ *Pa* after closing the plating chamber. At the same time, turning on the resistive heater to heat the silver cadmium oxide semi-finished strip to 400°C. After the vacuum degree reaches the required value, turning off the vacuum pump and the exhaust valve of the plating chamber, filling the plating chamber with high-purity argon gas, and turning on the DC power supply for 1 *h* to deposit the fine silver material on the external surface of the silver cadmium oxide semi-finished strip by sputtering process to obtain silver cadmium oxide/silver strip. The thickness of the silver plating layer is 0.01 *mm.*
d) Slitting the silver cadmium oxide/silver strip to 4×0.86 *mm* and processing to 4×0.80 *mm* by profile rolling. During profile rolling, rolling pattern mark on the surface of silver plating layer. cutting and blanking the strip according to a length of 4 *mm* to obtain the silver cadmium oxide/silver electrical contact semi-finished tips. After the surface treatment of the silver cadmium oxide/silver electrical contact semi-finished tips, rejecting the products with poor appearance and size by visual sorting equipment, packaging the qualified products and pasting with labels automatically to obtain silver cadmium oxide/silver finished contacts. Specification of the contacts is 4×4×0.8 *mm,* the thickness of silver plating layer is 0.01 *mm,* the distribution range of the silver plating layer is ±0.005 *mm,* and the bonding strength of the silver plating layer is ≥100 *N*/*mm²* after brazing.

According to the shape of the above silver cadmium oxide/silver substrate, there are different preparation routes.
Route 1: Melting → turning → extruding → rolling → internal oxidation of the strip → surface treatment → plating silver by magnetron sputtering → punching → surface treatment → spot inspection and packaging.
Route 2: Melting → turning → extruding → rolling → internal oxidation of the strip → surface treatment → plating silver by magnetron sputtering → slitting → profile rolling → cutting→ surface treatment → spot inspection and packaging.

Example 4, the AgMeO substrate is silver cadmium oxide.
a) 21 *kg* silver, 3.75 *kg* cadmium and 0.25 *kg* additive are melted in graphite crucible of medium frequency melting furnace, then casting the molten liquid to form silver-cadmium alloy ingots with a size of φ90 *mm,* and after turning, the clean silver-cadmium alloy ingots with a size of φ88 *mm* are obtained.
b) Heating the silver-cadmium alloy ingots to 750°C in medium frequency heating equipment, extruding them to a strip with a size of 60×5 *mm,* and rolling the strip to a size of 60×2.40 *mm* to obtain silver-cadmium alloy semi-finished strip. After internal oxidation treatment of the silver-cadmium alloy semi-finished strip, the silver cadmium oxide strip with 83% silver content is obtained. After removing the impurities and oil stains of the strip by surface treatment, silver cadmium oxide semi-finished strip is obtained.
c) Winding the silver cadmium oxide semi-finished strip on the barrel of the magnetron sputtering equipment tightly, loading the barrel into the magnetron sputtering equipment for plating silver, installing the fine silver target, and pre-vacuumizing the plating chamber to ≤5×10⁻⁴ *Pa* after closing the plating chamber. At the same time, turning on the resistive heater to heat the silver cadmium oxide semi-finished strip to 350°C. After the vacuum degree reaches the required value, turning off the vacuum pump and the exhaust valve of the plating chamber, filling the plating chamber with high-purity argon gas, and turning on the DC power supply for 10 *h* to deposit the fine silver material on the external surface of the silver cadmium oxide semi-finished strip by sputtering process to obtain silver cadmium oxide/silver strip. The thickness of the silver plating layer is 0.10 *mm.*
d) Preparing silver cadmium oxide/silver electrical contact semi-finished tips using the silver cadmium oxide/silver strip in the manner of punching and blanking, and stamping the pattern mark on the surface of the silver plating layer during punching process. After the surface treatment of the silver cadmium oxide/silver electrical contact semi-finished tips, rejecting the products with poor appearance and size by visual sorting equipment, packaging the qualified products and pasting with labels automatically to obtain silver cadmium oxide/silver finished contacts. Specification of the contacts is 28×18×2.5 *mm,* the thickness of silver plating layer is *0.10 mm,* the distribution range of the silver plating layer is ±0.005 *mm,* and the bonding strength of the silver plating layer is ≥100 *N*/*mm²* after brazing.

According to the shape of the above silver cadmium oxide/silver substrate, there are different preparation routes.
Route 1: Melting → turning → extruding → rolling → internal oxidation of the strip → surface treatment → plating silver by magnetron sputtering → punching → surface treatment → spot inspection and packaging.
Route 2: Melting → turning → extruding → rolling → internal oxidation of the strip → surface treatment → plating silver by magnetron sputtering → slitting → profile rolling → cutting → surface treatment → spot inspection and packaging.

Example 5, the AgMeO substrate is silver copper oxide.
a) 18.3 *kg* silver and 1.7 *kg* copper are melted in graphite crucible of medium frequency melting furnace to form molten liquid of silver-copper alloy. Silver-copper alloy powder is prepared using the molten liquid of silver-copper alloy by high pressure water atomization equipment. Silver copper oxide powder with 90% silver content is prepared by drying, sieving and oxidizing of silver copper alloy powder .
b) The silver copper oxide powder is pressed to ingots with a size of φ105 *mm* by cold isostatic pressing equipment. After sintering at 800°C for 4 hours, the ingots are extruded to a strip with a size of 40×3 *mm* and then the strip is rolled to a size of 40×1.4 *mm.* After surface treatment, the impurities and oil stains on the surface of the strip are removed, and the silver copper oxide semi-finished strip is obtained.
c) Winding the silver copper oxide semi-finished strip on the barrel of the magnetron sputtering equipment tightly, loading the barrel into the magnetron sputtering equipment using for silver plating, installing the fine silver target, and pre-vacuumizing the plating chamber to ≤5×10⁻⁴ *Pa* after closing the plating chamber. At the same time, turning on the resistive heater to heat the silver copper oxide semi-finished strip to 400°C. After the vacuum degree reaches the required value, turning off the vacuum pump and the exhaust valve of the plating chamber, filling the plating chamber with high-purity argon gas, and turning on the DC power supply for 5 *h* to deposit the fine silver material on the external surface of the silver copper oxide semi-finished strip by sputtering process to obtain silver copper oxide/silver strip. The thickness of the silver plating layer is 0.10 *mm.*
d) Preparing silver copper oxide/silver electrical contact semi-finished tips using the silver copper oxide/silver strip in the form of punching and blanking, and stamping the pattern mark on the surface of the silver plating layer during punching process. After the surface treatment of the silver copper oxide/silver electrical contact semi-finished tips, rejecting the products with poor appearance and size by visual sorting equipment, packaging the qualified products and pasting with labels automatically to obtain silver copper oxide/silver finished contacts. Specification of the contacts is φ16×1.5 *mm,* the thickness of silver plating layer is 0.10 *mm,* the distribution range of the silver plating layer is ±0.005 *mm,* and the bonding strength of the silver plating layer is ≥100 *N*/*mm²* after brazing.

According to the shape of the above silver copper oxide/silver substrate, there are different preparation routes.
Route 1: Atomizing → powder oxidation → isostatic pressing → sintering → extruding → rolling → surface treatment → plating silver by magnetron sputtering → punching → surface treatment → spot inspection and packaging.
Route 2: Atomizing → powder oxidation → isostatic pressing → sintering → extruding → rolling → surface treatment → plating silver by magnetron sputtering → slitting → profile rolling → cutting→ surface treatment → spot inspection and packaging.

Example 6, the AgMeO substrate is silver zinc oxide.
a) 25 *kg* silver powder and 2.5 *kg* zinc oxide powder are mixed in plough shovel mixer for 6 *h* to prepare silver zinc oxide powder with 90% silver content, wherein, silver powder is - *200 mesh* and the average particle size of zinc oxide powder is 2 *µm.*
b) The silver zinc oxide powder is pressed to ingots with a size of φ88 *mm* by cold isostatic pressing equipment. After sintering at 800°C for 4 hours, the ingots are extruded to a strip with a size of 45×4 *mm* and then the strip is rolled to a size of 45×2.35 *mm.* After surface treatment, the impurities and oil stains on the surface of the strip are removed, and the silver zinc oxide semi-finished strip is obtained.
c) Winding the silver zinc oxide semi-finished strip on the barrel of the magnetron sputtering equipment tightly, loading the barrel into the magnetron sputtering equipment for plating silver, installing the fine silver target, and pre-vacuumizing the plating chamber to ≤5×10⁻⁴ *Pa* after closing the plating chamber. At the same time, turning on the resistive heater to heat the silver zinc oxide semi-finished strip to 350°C. After the vacuum degree reaches the required value, turning off the vacuum pump and the exhaust valve of the plating chamber, filling the plating chamber with high-purity argon gas, and turning on the DC power supply for 6 *h* to deposit the fine silver material on the external surface of the silver zinc oxide semi-finished strip by sputtering process to obtain silver zinc oxide/silver strip. The thickness of the silver plating layer is 0.06 *mm.*
d) Slitting the silver zinc oxide/silver strip to a size of 9.85×2.41 *mm* and processing it to a size of 10×2.00 *mm* by profile rolling. During profile rolling, rolling the pattern mark on the surface of silver plating layer. cutting and blanking the strip according to a length of 35 *mm* to obtain silver zinc oxide/silver electrical contact semi-finished tips. After the surface treatment of the silver zinc oxide/silver electrical contact semi-finished tips, rejecting the products with poor appearance and size by visual sorting equipment, packaging the qualified products and pasting with labels automatically to obtain silver zinc oxide/silver finished contacts. Specification of the contacts is 35×10×2 *mm,* the thickness of silver plating layer is 0.05 *mm,* the distribution range of the silver plating layer is ±0.005 *mm,* and the bonding strength of the silver plating layer is ≥100*N*/*mm²* after brazing.

According to the shape of the above silver zinc oxide/silver substrate, there are different preparation routes.
Route 1: Preparing powder → mixing powder → isostatic pressing → sintering → extruding → rolling → surface treatment → plating silver by magnetron sputtering → punching → surface treatment → spot inspection and packaging.
Route 2: Preparing powder → mixing powder → isostatic pressing → sintering → extruding → rolling → surface treatment → plating silver by magnetron sputtering → slitting → profile rolling → cutting → surface treatment → spot inspection and packaging.

Example 7, the AgMeO substrate is silver iron oxide.
a) 22.5 *kg* silver powder and 2.5 *kg* iron oxide powder are mixed in plough shovel mixer for 5 *h* to prepare silver iron oxide powder with 90% silver content, wherein, the silver powder is *-*350 *mesh* and the average particle size of the iron oxide powder is *5 µm.*
b) The silver iron oxide powder is pressed to ingots with a size of φ88 *mm* by cold isostatic pressing equipment. After sintering at 850°C for 5 hours, the ingots are extruded to a strip with a size of 50×4 *mm* and then the strip is rolled to a size of 50×1.47 *mm.* After surface treatment, the impurities and oil stains on the surface of the strip are removed, and the silver iron oxide semi-finished strip is obtained.
c) Winding the silver iron oxide semi-finished strip on the barrel of the magnetron sputtering equipment tightly, loading the barrel into the magnetron sputtering equipment using for plating silver, installing the fine silver target, and pre-vacuumizing the plating chamber to ≤5×10⁻⁴ *Pa* after closing the plating chamber. At the same time, turning on the resistive heater to heat the silver iron oxide semi-finished strip to 450°C. After the vacuum degree reaches the required value, turning off the vacuum pump and the exhaust valve of the plating chamber, filling the plating chamber with high-purity argon gas, and turning on the DC power supply for 3 *h* to deposit the fine silver material on the external surface of the silver iron oxide semi-finished strip by sputtering process to obtain silver iron oxide/silver strip. The thickness of the silver plating layer is 0.03 *mm.*
d) Preparing silver iron oxide/silver electrical contact semi-finished tips using the silver iron oxide/silver strip in the form of punching and blanking, and stamping the pattern mark on the surface of silver plating layer during punching process. After the surface treatment of the silver iron oxide/silver electrical contact semi-finished tips, rejecting the products with poor appearance and size by visual sorting equipment, packaging the qualified products and pasting with labels automatically to obtain silver iron oxide/silver finished contacts. Specification of the contacts is (5+7)×8×1.50 *mm,* the thickness of silver plating layer is 0.03 *mm,* the distribution range of the silver plating layer is ±0.005 *mm,* and the bonding strength of the silver plating layer is ≥100 *N*/*mm²* after brazing.

According to the shape of the above silver iron oxide/silver substrate, there are different preparation routes.
Route 1: Preparing powder → mixing powder → isostatic pressing → sintering → extruding → rolling → surface treatment → plating silver by magnetron sputtering → punching → surface treatment → spot inspection and packaging.
Route 2: Preparing powder → mixing powder → isostatic pressing → sintering → extruding → rolling → surface treatment → plating silver by magnetron sputtering → slitting → profile rolling → cutting → surface treatment → spot inspection and packaging.

Example 8, the AgMeO substrate is silver tin oxide indium oxide.
a) 22 *kg* silver, 2 *kg* tin and 1 *kg* indium are melted in graphite crucible of medium frequency melting furnace to form melt of silver-tin-indium alloy. Silver-tin-indium alloy powder is prepared using the melt of silver-tin-indium alloy by high pressure water atomization equipment. Silver tin oxide indium oxide powder with 85% silver content is prepared by drying, sieving and oxidizing the silver-tin-indium alloy powder.
b) The silver tin oxide indium oxide powder is pressed to ingots with a size of φ105 *mm* by cold isostatic pressing equipment. After sintering at 850°C for 4 hours, the ingots are extruded to a wire with a size of φ12 *mm* and then the wire is drew to a size of φ8 *mm.* After annealing treatment, the wire is processed to silver tin oxide indium oxide solid contact tip with a size of φ15×3.8 *mm* by cold heading. During cold heading, manufacturing pattern mark on the welding surface of the contact tip. The depth of the pattern mark is 0.3 *mm.*
c) Cleaning the silver tin oxide indium oxide solid contact tip in ultrasonic cleaning equipment to remove oil, and then drying it to obtain silver tin oxide indium oxide tip blank with a clean surface and no organic residue.
d) Placing the silver tin oxide indium oxide tip blank in the tray with the pattern side upward, placing the tray in the magnetron sputtering equipment, installing the fine silver target, pre-vacuumizing the plating chamber to ≤5×10⁻⁴ *Pa* after closing the plating chamber, and at the same time, turning on the resistive heater to heat the silver tin oxide indium oxide tip blank to 480°C. After the vacuum degree reaches the required value, turning off the vacuum pump and the exhaust valve of the plating chamber, filling the plating chamber with high-purity argon gas, and turning on the DC power for 20 *h* supply to deposit the fine silver material on the pattern side of the silver tin oxide indium oxide tip blank by sputtering process.
e) Rejecting the products with poor appearance and size by visual sorting equipment, packaging the qualified products and pasting with labels automatically to obtain silver tin oxide indium oxide finished contacts with silver plating layer. Specification of the contacts is φ15×3 *mm,* the thickness of silver plating layer is 0.20 *mm,* the distribution range of the silver plating layer is ±0.005 *mm,* and the bonding strength of the silver plating layer is ≥100 N/mm² after brazing.

The preparation route of the silver tin oxide indium oxide/silver is as follows.
Route: Atomizing → powder oxidation → isostatic pressing → sintering → extruding → drawing → annealing → cold heading → surface treatment → plating silver by magnetron sputtering → spot inspection and packaging.

Example 9, the AgMeO substrate is silver tin oxide.
a) 19.5 *kg* silver powder, 2.73 *kg* tin oxide powder and 0.5 *kg* additive powder are mixed in plough shovel mixer for 4 *h* to prepare silver tin oxide powder with 88% silver content, wherein, the silver powder is -200 *mesh,* the average particle size of the tin oxide powder is 5 *µm,* and the average particle size of the additive powder is 2 *µm.*
b) The silver tin oxide powder is pressed to ingots with a size of φ88 *mm* by cold isostatic pressing equipment. After sintering at 900°C for 6 hours, the ingots are extruded to a wire with a size of φ5 *mm* and then the wire is drew to a size of φ1.38 *mm.* After annealing treatment, the wire is processed to silver tin oxide solid contact tip with a size of φ2×0.19 *mm* by cold heading. During cold heading, manufacturing pattern mark on the welding surface of the contact tip. The depth of the pattern mark is 0.05 *mm.*
c) Cleaning the silver tin oxide solid contact tip in ultrasonic cleaning equipment to remove oil, and then drying it to obtain silver tin oxide tip blank with a clean surface and no organic residue.
d) Placing the silver tin oxide tip blank in the tray with the pattern side upward, placing the tray in the magnetron sputtering equipment, installing the fine silver target, pre-vacuumizing the plating chamber to ≤5×10⁻⁴ *Pa* after closing the plating chamber, and at the same time, turning on the resistive heater to heat the silver tin oxide tip blank to 450°C. After the vacuum degree reaches the required value, turning off the vacuum pump and the exhaust valve of the plating chamber, filling the plating chamber with high-purity argon gas, and turning on the DC power supply for 1 *h* to deposit the fine silver material on the pattern side of the silver tin oxide tip blank by sputtering process.
e) Rejecting the products with poor appearance and size by visual sorting equipment, packaging the qualified products and pasting with labels automatically to obtain silver tin oxide finished contacts with silver plating layer. Specification of the contacts is φ2×0.2 *mm,* the thickness of silver plating layer is 0.01 *mm,* the distribution range of the silver plating layer is ±0.005 *mm,* and the bonding strength of the silver plating layer is ≥100 *N*/*mm²* after brazing.

The preparation route of the above silver tin oxide/silver is as follows.
Route: Preparing powder → mixing powder → isostatic pressing → sintering → extruding → drawing → annealing → cold heading → surface treatment → plating silver by magnetron sputtering → spot inspection and packaging.

Example 10, the AgMeO substrate is silver cadmium oxide.
a) 21.350 *kg* silver, 3.375 *kg* cadmium and 0.275 *kg* additive are melted in graphite crucible of bead spreader, and then silver-cadmium alloy balls are prepared by the bead spreader. After drying, sorting and oxidizing of the silver-cadmium alloy balls, the silver cadmium oxide alloy balls with 85% silver content is prepared.
b) The silver cadmium oxide alloy balls are pressed to ingots with a size of φ88 *mm* by four column hydraulic presser. After sintering at 880°C for 5 hours, the ingots are extruded to a wire stock with a size of φ6 *mm* and then the wire is drew to a size of φ4.5 *mm.* After annealing, the wire is processed to silver cadmium oxide solid contact tip with a size of φ8×2SR35 *mm* by cold heading. During cold heading, manufacturing pattern mark on the welding surface of the contact tip. The depth of the pattern mark is 0.15 *mm.*
c) Cleaning the silver cadmium oxide solid contact tip in ultrasonic cleaning equipment to remove oil, and then drying it to obtain silver cadmium oxide tip blank with a clean surface and no organic residue.
d) Placing the silver cadmium oxide tip blank in the tray with the pattern side upward, placing the tray in the magnetron sputtering equipment, installing the fine silver target, pre-vacuumizing the plating chamber to ≤5×10⁻⁴ *Pa* after closing the plating chamber, and at the same time, turning on the resistive heater to heat the silver cadmium oxide tip blank to 300°C. After the vacuum degree reaches the required value, turning off the vacuum pump and the exhaust valve of the plating chamber, filling the plating chamber with high-purity argon gas, and turning on the DC power supply for 10 *h* to deposit the fine silver material on the pattern side of the silver cadmium oxide tip blank by sputtering process.
e) Rejecting the products with poor appearance and size by visual sorting equipment, packaging the qualified products and pasting with labels automatically to obtain silver cadmium oxide finished contacts with silver plating layer. Specification of the contacts is φ8×2.1SR35 *mm,* the thickness of silver plating layer is 0.10 *mm,* the distribution range of the silver plating layer is ±0.005 *mm,* and the bonding strength of the silver plating layer is ≥100 *N*/*mm²* after brazing.

The preparation route of the silver cadmium oxide/silver is as follows.
Route: Preparing silver alloy particles → internal oxidation → surface treatment → isostatic pressing → extruding → drawing → annealing → cold heading → surface treatment → plating silver by magnetron sputtering → spot inspection and packaging.

Example 11, the AgMeO substrate is silver cadmium oxide.
a) 20.625 *kg* silver and 4.375 *kg* cadmium are melted in the graphite crucible of medium frequency melting furnace, then casting the molten liquid to form silver-cadmium alloy ingots with a size of φ90 *mm,* and after turning, the clean silver-cadmium alloy ingots with a size of φ88 *mm* are obtained.
b) Heating the silver-cadmium alloy ingots to 700°C in medium frequency heating equipment, extruding them to silver-cadmium alloy wire with a size of φ6.0 *mm,* and then drawing to a size of φ2.38 *mm.* After annealing treatment, the wire is processed to silver-cadmium alloy solid contact tip with a size of φ5×1.15 *mm* by cold heading. During cold heading, manufacturing pattern mark on the welding surface of the contact tip. The depth of the pattern mark is 0.10 *mm.*
c) The silver cadmium oxide solid contact tip with 80% silver content is obtained after internal oxidation treatment of the silver-cadmium alloy solid contact tip. After acid pickling and polishing the silver cadmium oxide solid contact tip, then cleaning it in the ultrasonic cleaning equipment to remove oil, then drying it, the silver cadmium oxide tip blank with clean surface and no organic residue is obtained.
d) Placing the silver cadmium oxide tip blank in the tray with the pattern side upward, placing the tray in the magnetron sputtering equipment, installing the fine silver target, and pre-vacuumizing the plating chamber to ≤5×10⁻⁴ *Pa* after closing the plating chamber. At the same time, turning on the resistive heater to heat the silver cadmium oxide tip blank to 400°C. After the vacuum degree reaches the required value, turning off the vacuum pump and the exhaust valve of the plating chamber, filling the plating chamber with high-purity argon gas, and turning on the DC power supply for 5 *h* to deposit the fine silver material on the pattern side of the silver cadmium oxide tip blank by sputtering process.
e) Rejecting the products with poor appearance and size by visual sorting equipment, packaging the qualified products and pasting with labels automatically to obtain silver cadmium oxide finished contacts with silver plating layer. Specification of the contacts is φ5×1.2 *mm,* the thickness of the silver plating layer is 0.05 *mm,* the distribution range of the silver plating layer is ±0.005 *mm,* and the bonding strength of the silver plating layer is ≥100 *N*/*mm²* after brazing.

The preparation route of the silver cadmium oxide/silver is as follows.
Route: Melting → turning → extruding → drawing → annealing → cold heading → internal oxidation → surface treatment → plating silver by magnetron sputtering → spot inspection and packaging.

Example 12, the AgMeO substrate is silver copper oxide.
a) 18.3 *kg* silver and 1.7 *kg* copper are melted in graphite crucible of medium frequency melting furnace to form molten liquid of silver-copper alloy. Silver-copper alloy powder is prepared using the molten liquid of silver-copper alloy by high pressure water atomization equipment. Silver copper oxide powder with 85% silver content is prepared by drying, sieving and oxidizing the silver-copper alloy powder.
b) The silver copper oxide powder is pressed to ingots with a size of φ105 *mm* by cold isostatic pressing equipment. After sintering at 800°C for 5 hours, the ingots are extruded to a wire with a size of φ8 *mm* and then the wire is drew to a size of φ5 *mm.* After annealing treatment, the wire is processed to silver copper oxide solid contact tip with a size of φ10×1.95 *mm* by cold heading. During cold heading, manufacturing pattern mark on the welding surface of the contact tip. The depth of the pattern mark is 0.20 *mm.*
c) Cleaning the silver copper oxide solid contact tip in ultrasonic cleaning equipment to remove oil, and then drying it to obtain silver copper oxide tip blank with a clean surface and no organic residue.
d) Placing the silver copper oxide tip blank in the tray with the pattern side upward, placing the tray in the magnetron sputtering equipment, installing the fine silver target, and pre-vacuumizing the plating chamber to ≤5×10⁻⁴ *Pa* after closing the plating chamber. At the same time, turning on the resistive heater to heat the silver copper oxide tip blank to 420°C. After the vacuum degree reaches the required value, turning off the vacuum pump and the exhaust valve of the plating chamber, filling the plating chamber with high-purity argon gas, and turning on the DC power supply for 5 *h* to deposit the fine silver material on the pattern side of the silver copper oxide tip blank by sputtering process.
e) Rejecting the products with poor appearance and size by visual sorting equipment, packaging the qualified products and pasting with labels automatically to obtain silver copper oxide finished contacts with silver plating layer. Specification of the contacts is φ10×2 *mm,* the thickness of silver plating layer is 0.05 *mm,* the distribution range of the silver plating layer is ±0.005 *mm,* and the bonding strength of the silver plating layer is ≥100 *N*/*mm²* after brazing.

The preparation route of the silver copper oxide/silver is as follows.
Route: Atomizing → powder oxidation → isostatic pressing → sintering → extruding → drawing → annealing → cold heading → surface treatment → plating silver by magnetron sputtering → spot inspection and packaging.

Example 13, the AgMeO substrate is silver zinc oxide.
a) Mixing 22.8 *kg* silver powder, 2 *kg* zinc oxide powder and 0.2 *kg* additive powder in plough shovel mixer for 6 *h* to prepare silver zinc oxide powder with 92% silver content, wherein, the silver powder is -200 *mesh,* the average particle size of the zinc oxide powder is 2 *µm,* and the average particle size of the additive powder is 1 *µm.*
b) The silver zinc oxide powder is pressed to ingots with a size of φ88 *mm* by cold isostatic pressing equipment. After sintering at 800°C for 4 hours, the ingots are extruded to a wire with a size of φ8 *mm,* and then the wire is drew to a size of φ6 *mm.* After annealing treatment, the wire is processed to silver zinc oxide solid contact tip with a size of 12×12×3.9R60 *mm* by cold heading. During cold heading, manufacturing pattern mark on the welding surface of the contact tip. The depth of the pattern mark is 0.15 *mm.*
c) Cleaning the silver zinc oxide solid contact tip in ultrasonic cleaning equipment to remove oil, and then drying it to obtain silver zinc oxide tip blank with a clean surface and no organic residue.
d) Placing the silver zinc oxide tip blank in the tray with the pattern side upward, placing the tray in the magnetron sputtering equipment, installing the fine silver target, and pre-vacuumizing the plating chamber to ≤5×10⁻⁴ *Pa* after closing the plating chamber. At the same time, turning on the resistive heater to heat the silver zinc oxide tip blank to 460°C. After the vacuum degree reaches the required value, turning off the vacuum pump and the exhaust valve of the plating chamber, filling the plating chamber with high-purity argon gas, and turning on the DC power supply for 10 *h* to deposit the fine silver material on the pattern side of the silver zinc oxide tip blank by sputtering process.
e) Rejecting the products with poor appearance and size by visual sorting equipment, packaging the qualified products and pasting with labels automatically to obtain silver zinc oxide finished contacts with silver plating layer. Specification of the contacts is 12×12×4R60 *mm,* the thickness of silver plating layer is 0.10 *mm,* the distribution range of the silver plating layer is ±0.005 *mm,* and the bonding strength of the silver plating layer is ≥100 *N*/*mm²* after brazing.

The preparation route of the silver zinc oxide/silver is as follows.
Route: Preparing powder → mixing powder → isostatic pressing → sintering → extruding → drawing → annealing → cold heading → surface treatment → plating silver by magnetron sputtering → spot inspection and packaging.

Example 14, the AgMeO substrate is silver iron oxide.
a) Mixing 22.5 *kg* silver powder and 2.5 *kg* iron oxide powder in plough shovel mixer for 5 *h* to prepare silver iron oxide powder with 90% silver content, wherein, the silver powder is *-350 mesh* and the average particle size of the iron oxide powder is *5 µm.*
b) The silver iron oxide powder is pressed to ingots with a size of φ88 *mm* by cold isostatic pressing equipment. After sintering at 880°C for 8 hours, the ingots are extruded to a wire with a size of φ6 *mm,* and then the wire is drew to a size of φ1.88 *mm.* After annealing treatment, the wire is processed to silver iron oxide solid contact tip with a size of 4×4×0.77 *mm* by cold heading. During cold heading, manufacturing pattern mark on the welding surface of the contact tip. The depth of the pattern mark is 0.05 *mm.*
c) Cleaning the silver iron oxide solid contact tip in ultrasonic cleaning equipment to remove oil, and then drying it to obtain silver iron oxide tip blank with a clean surface and no organic residue.
d) Placing the silver iron oxide tip blank in the tray with the pattern side upward, placing the tray in the magnetron sputtering equipment, installing the fine silver target, pre-vacuumizing the plating chamber to ≤5×10⁻⁴ *Pa* after closing the plating chamber, and at the same time, turning on the resistive heater to heat the silver iron oxide tip blank to 450°C. After the vacuum degree reaches the required value, turning off the vacuum pump and the exhaust valve of the plating chamber, filling the plating chamber with high-purity argon gas, and turning on the DC power supply for 3 *h* to deposit the fine silver material on the pattern side of the silver iron oxide tip blank by sputtering process.
e) Rejecting the products with poor appearance and size by visual sorting equipment, packaging the qualified products and pasting with labels automatically to obtain silver iron oxide finished contacts with silver plating layer. Specification of the contacts is 4×4×0.8 *mm,* the thickness of silver plating layer is 0.03 *mm,* the distribution range of the silver plating layer is ±0.005 *mm,* and the bonding strength of the silver plating layer is ≥100 *N*/*mm²* after brazing.

The preparation route of the above silver iron oxide/silver is as follows.
Route: Preparing powder → mixing powder → isostatic pressing → sintering → extruding → drawing → annealing → cold heading → surface treatment → plating silver by magnetron sputtering → spot inspection and packaging.

An additional improvement is proposed as follows. The silver target is designed as a curved surface, the concave surface of the curved surface is toward the AgMeO substrate, and the diameter of the curved surface is 1.5~2 times of the distance between the target and the substrate. Because the silver atoms at the sputtering place are neutral, they cannot be controlled by the electric field, and the silver atoms sputtered from the target have a higher speed, which is not conducive to deposit on the substrate. And due to the stability of the electric field and magnetic field, the distribution of silver atoms is relatively concentrated. Therefore, the structure of the silver target is designed as a curved structure. On the one hand, the Ar ions impact the silver target at a non rectangular angle, which promotes the Ar ions to transfer part of the energy along the transverse direction of the target when impacting the silver target, so as to improve the separation efficiency of silver atoms and reduce the impact energy converted to the internal energy of the silver target. And on the other hand, the silver atoms impacted out from the both sides of the center of the silver target move cross each other and collide with each other in the process, thus reducing their moving speed and macroscopically making the silver atoms moving path more uniform which is convenient for uniform deposition on the substrate. Therefore, in the case of improving the quality of silver plating, there is no need to reduce the sputtering power to guarantee the sputtering effect and production speed.

## Claims

1. A method for preparing electrical contact tips of silver metal oxide, **characterized in that**, comprising:
plating silver on AgMeO substrate by magnetron sputtering process, thickness of silver plating layer is 0.01 *mm~0.20 mm,* distribution uniformity of silver layer is ±0.005 *mm,* and
during plating silver by magnetron sputtering process, the AgMeO substrate is heated and kept at 30%-65% of a melting point of the AgMeO substrate,
wherein the AgMeO is one of silver tin oxide, silver copper oxide, silver zinc oxide, silver tin oxide indium oxide, silver cadmium oxide or silver iron oxide.

2. The method for preparing electrical contact tips of silver metal oxide according to the claim 1, **characterized in that**, the AgMeO substrate is round or quadrate, and the method comprises the following steps:
① preparing AgMeO wire: preparing AgMeO wire by conventional internal oxidation process, pre-oxidation process or powder metallurgy process, etc., and processing the AgMeO wire by drawing and annealing to required specification and state;
② forming by cold heading: the AgMeO wire is processed to AgMeO tip blank by cold heading equipment, and welding surface of the AgMeO tip blank is marked with pattern during forming by cold heading;
③ surface treatment: the AgMeO tip blank is cleaned by ultrasonic cleaning equipment to remove oil, and then the AgMeO tip blank with clean surface and no organic residue is obtained;
④ plating silver by magnetron sputtering: arranging the AgMeO tip blank in a tray with pattern side upward, placing the tray in a magnetron sputtering equipment, installing a fine silver target, pre-vacuumizing plating chamber to ≤5 ×10⁻⁴ *Pa* after closing the plating chamber, turning off vacuum pump and exhaust valve of the plating chamber after vacuum degree of the plating chamber reaches the required value, filling the plating chamber with high-purity argon gas, and turning on a DC power supply to deposit fine silver material on the pattern side of the AgMeO tip blank by sputtering process, wherein bias current is 0.01~0.10 A, bias voltage is 10~100 *V*, and time is 1~30 *h;* and
⑤ spot inspection and packaging: rejecting the products with poor appearance and size by visual sorting equipment, packaging the qualified products and pasting with labels automatically to obtain finished contacts of AgMeO/Ag.

3. The method for preparing electrical contact tips of silver metal oxide according to the claim 1, **characterized in that**, the AgMeO substrate is square or rectangular, and the method comprises the following steps:
① preparing AgMeO strip: preparing AgMeO strip by conventional internal oxidation process, pre-oxidation process or powder metallurgy process, etc., rolling the AgMeO strip to a thickness of semi-finished products, and removing impurities and oil stains on a surface of the AgMeO strip by surface treatment;
② plating silver by magnetron sputtering: winding the AgMeO strip on a barrel of a magnetron sputtering equipment tightly, loading the barrel into the magnetron sputtering equipment for plating silver, installing a fine silver target, pre-vacuumizing plating chamber to ≤5×10⁻⁴ *Pa* after closing the plating chamber, turning off vacuum pump and exhaust valve of the plating chamber after the vacuum degree of the plating chamber reaches the required value, filling the plating chamber with high-purity argon gas, and turning on a DC power supply to deposit fine silver material on an external surface of the AgMeO strip by sputtering process to obtain AgMeO/Ag strip, wherein bias current is 0.01~0.10 *A*, bias voltage is 10~100 *V,* and time is 1~30 *h;* and
③ slitting the AgMeO/Ag strip to a width of semi-finished products, and processing the AgMeO/Ag strip to a width, thickness and shape of finished products by profile rolling; at the same time, pattern mark is rolled on a surface of silver plating layer during profile rolling; then AgMeO/Ag electrical contact semi-finished tips are obtained by cutting and blanking according to a length requirement of the finished products; after surface treatment of the AgMeO/Ag electrical contact semi-finished tips, rejecting products with poor appearance and size by visual sorting equipment, packaging qualified products and pasting with labels automatically to obtain finished contacts of AgMeO/Ag.

4. The method for preparing electrical contact tips of silver metal oxide according to the claim 1, **characterized in that**, shape of the AgMeO substrate is irregular, and the method comprises the following steps:
① preparing AgMeO strip: preparing AgMeO strip by conventional internal oxidation process, pre-oxidation process or powder metallurgy process, etc., rolling the AgMeO strip to a thickness of semi-finished products, and removing impurities and oil stains on a surface of the AgMeO strip by surface treatment;
② plating silver by magnetron sputtering: winding the AgMeO strip on a barrel of a magnetron sputtering equipment tightly, loading the barrel into the magnetron sputtering equipment for plating silver, installing a fine silver target, pre-vacuumizing plating chamber to ≤5×10⁻⁴ *Pa* after closing the plating chamber, turning off vacuum pump and exhaust valve of the plating chamber after vacuum degree of the plating chamber reaches the required value, filling the plating chamber with high-purity argon gas, and turning on a DC power supply to deposit fine silver material on an external surface of the AgMeO strip by sputtering process to obtain AgMeO/Ag strip, wherein bias current is 0.01~0.10 *A*, bias voltage is 10~100 *V*, and time is 1~30 *h;* and
③ preparing AgMeO/Ag electrical contact semi-finished tips using the AgMeO/Ag strip in a manner of punching and blanking, and stamping pattern mark on a surface of silver plating layer during punching process; and after a surface treatment of the AgMeO/Ag electrical contact semi-finished tips, rejecting products with poor appearance and size by visual sorting equipment, packaging qualified products and pasting with labels automatically to obtain finished contacts of AgMeO/Ag.

5. The method for preparing electrical contact tips of silver metal oxide according to the claim 1, **characterized in that**, during plating silver by magnetron sputtering process, the AgMeO substrate is heated and kept at a temperature of 300-600°C.

6. The method for preparing electrical contact tips of silver metal oxide according to the claim 5, **characterized in that**, during plating silver by magnetron sputtering process,
when the AgMeO substrate is silver tin oxide, the silver tin oxide substrate is heated and kept at a temperature of 350~450°C;
when the AgMeO substrate is silver copper oxide, the silver copper oxide substrate is heated and kept at a temperature of 300~420°C;
when the AgMeO substrate is silver zinc oxide, the silver zinc oxide substrate is heated and kept at a temperature of 320~460°C;
when the AgMeO substrate is silver iron oxide, the silver iron oxide substrate is heated and kept at a temperature of 300~450°C;
when the AgMeO substrate is silver cadmium oxide, the silver cadmium oxide substrate is heated and kept at a temperature of 300~400°C; and
when the AgMeO substrate is silver tin oxide indium oxide, the silver tin oxide indium oxide substrate is heated and kept at a temperature of 320~480°C.

7. The method for preparing electrical contact tips of silver metal oxide according to the claim 6, **characterized in that**, other parameters of the magnetron sputtering process are as follows:
sputtering power is 500~1500 *W,* sputtering gas pressure is 3.5~4.5 *mTorr,* gas flow of Ar is 25~35 *sccm,* and distance between the target and the substrate is 6 ~ 15 *cm.*

## Patentansprüche

1. Ein Verfahren zur Herstellung elektrischer Kontaktspitzen aus Silbermetalloxid, **dadurch gekennzeichnet, dass** es umfasst:
das Aufbringen einer Silberschicht auf ein AgMeO-Substrat mittels Magnetron-Sputterverfahren, wobei die Dicke der Silberschicht 0,01 *mm* bis 0,20 *mm* beträgt*,* die Gleichmäßigkeit der Silberschicht ±0,005 *mm* beträgt, und
während des Aufbringens der Silberschicht durch Magnetron-Sputterverfahren das AgMeO-Substrat auf 30 % bis 65 % seines Schmelzpunkts erhitzt und auf dieser Temperatur gehalten wird,
wobei das AgMeO eines der folgenden ist: Silber-Zinn-Oxid, Silber-Kupfer-Oxid, Silber-Zink-Oxid, Silber-Zinn-Oxid-Indium-Oxid, Silber-Cadmium-Oxid oder Silber-Eisen-Oxid.

2. Das Verfahren zur Herstellung elektrischer Kontaktspitzen aus Silbermetalloxid gemäß Anspruch 1, **dadurch gekennzeichnet, dass** das AgMeO-Substrat rund oder quadratisch ist und das Verfahren die folgenden Schritte umfasst:
① Herstellen eines AgMeO-Drahts: Herstellen eines AgMeO-Drahts durch ein herkömmliches Innenoxidationsverfahren, ein Voroxidationsverfahren oder ein pulvermetallurgisches Verfahren usw. und Bearbeiten des AgMeO-Drahts durch Ziehen und Glühen auf die erforderliche Spezifikation und den erforderlichen Zustand;
② Umformen durch Kaltstauchen: Der AgMeO-Draht wird mit einer Kaltstauchanlage zu einem AgMeO-Spitzenrohling verarbeitet, und die Schweißfläche des AgMeO-Spitzenrohlings wird während des Kaltstauchens mit einem Muster markiert;
③ Oberflächenbehandlung: Der AgMeO-Spitzenrohling wird mit einer Ultraschallreinigungsanlage gereinigt, um Öl zu entfernen, wodurch ein AgMeO-Spitzenrohling mit sauberer Oberfläche und ohne organische Rückstände erhalten wird;
④ Silberbeschichtung durch Magnetron-Sputtern: Der AgMeO-Spitzenrohling wird mit der gemusterten Seite nach oben in eine Schale gelegt, die Schale wird in eine Magnetron-Sputteranlage eingesetzt, ein Feinsilber-Target wird installiert, die Beschichtungskammer wird nach dem Schließen auf einen Vorvakuumwert von ≤5×10⁻⁴ P*a,* nachdem die Beschichtungskammer geschlossen wurde; die Vakuumpumpe und das Ablassventil der Beschichtungskammer werden abgeschaltet, sobald der Vakuumgrad den erforderlichen Wert erreicht hat; die Beschichtungskammer wird mit hochreinem Argongas befüllt; und eine Gleichstromquelle wird eingeschaltet, um durch Sputterverfahren Feinsilbermaterial auf der Musterseite des AgMeO-Spitzenrohlings abzuscheiden, wobei der Vorspannungsstrom 0,01-0,10 *A* beträgt, die Vorspannung 10 bis 100 *V* beträgt und die Dauer 1 bis 30 *h* beträgt; und
⑤ Stichprobenprüfung und Verpackung: Aussortieren der Produkte mit mangelhaftem Erscheinungsbild und Abmessungen mittels einer visuellen Sortieranlage, Verpacken der qualifizierten Produkte und automatisches Anbringen von Etiketten, um fertige AgMeO/Ag-Kontakte zu erhalten.

3. Das Verfahren zur Herstellung elektrischer Kontaktspitzen aus Silbermetalloxid gemäß Anspruch 1, **dadurch gekennzeichnet, dass** das AgMeO-Substrat quadratisch oder rechteckig ist und das Verfahren die folgenden Schritte umfasst:
① Herstellung eines AgMeO-Bandes: Herstellung eines AgMeO-Bandes durch ein herkömmliches Innenoxidationsverfahren, ein Voroxidationsverfahren oder ein pulvermetallurgisches Verfahren usw., Walzen des AgMeO-Bandes auf die Dicke von Halbzeugen und Entfernen von Verunreinigungen und Ölflecken auf der Oberfläche des AgMeO-Bandes durch Oberflächenbehandlung;
② Aufbringen von Silber durch Magnetron-Sputtern: festes Aufwickeln des AgMeO-Bandes auf eine Trommel einer Magnetron-Sputteranlage, Einlegen der Trommel in die Magnetron-Sputteranlage zum Aufbringen von Silber, Anbringen eines Feinsilber-Targets, Vorvakuumieren der Beschichtungskammer auf ≤5×10⁻⁴ *Pa*; nach Erreichen des erforderlichen Vakuumgrads die Vakuumpumpe und das Ablassventil der Beschichtungskammer abschalten; die Beschichtungskammer mit hochreinem Argongas befüllen; eine Gleichstromversorgung einschalten, um durch Sputterverfahren Feinsilbermaterial auf die Außenfläche des AgMeO-Bandes abzuscheiden und so ein AgMeO/Ag-Streifen zu erhalten, wobei der Vorspannungsstrom 0,01-0,10 *A*, die Vorspannung 10-100 *V* und die Zeit 1-30 *h* beträgt; und
③ das AgMeO/Ag-Band auf die Breite von Halbzeugen geschlitzt und durch Profilwalzen auf die Breite, Dicke und Form der Endprodukte verarbeitet wird; gleichzeitig wird während des Profilwalzens ein Muster auf die Oberfläche der Silberbeschichtung aufgerollt; anschließend werden durch Schneiden und Stanzen entsprechend der Längenanforderung der Endprodukte elektrische Kontakt-Halbfertigspitzen aus AgMeO/Ag gewonnen; nach der Oberflächenbehandlung der elektrischen Kontakt-Halbfertigspitzen aus AgMeO/Ag werden Produkte mit mangelhaftem Aussehen und falschen Abmessungen durch visuelle Sortieranlagen aussortiert, qualifizierte Produkte verpackt und automatisch mit Etiketten versehen, um fertige Kontakte aus AgMeO/Ag zu erhalten.

4. Das Verfahren zur Herstellung von elektrischen Kontaktspitzen aus Silbermetalloxid gemäß Anspruch 1, **dadurch gekennzeichnet, dass** die Form des AgMeO-Substrats unregelmäßig ist und das Verfahren die folgenden Schritte umfasst:
① Herstellung eines AgMeO-Bandes: Herstellung eines AgMeO-Bandes durch ein herkömmliches Innenoxidationsverfahren, ein Voroxidationsverfahren oder ein pulvermetallurgisches Verfahren usw., Walzen des AgMeO-Bandes auf die Dicke der Halbzeuge und Entfernen von Verunreinigungen und Ölflecken auf der Oberfläche des AgMeO-Bandes durch Oberflächenbehandlung;
② Silberbeschichtung durch Magnetron-Sputtern: Das AgMeO-Band wird fest auf die Trommel einer Magnetron-Sputteranlage gewickelt, die Trommel wird zur Silberbeschichtung in die Magnetron-Sputteranlage eingesetzt, ein Feinsilber-Target wird installiert, die Beschichtungskammer wird auf ≤5×10⁻⁴ *Pa*, nach dem Schließen der Beschichtungskammer die Vakuumpumpe und das Ablassventil der Beschichtungskammer abschalten, sobald der Vakuumgrad der Beschichtungskammer den erforderlichen Wert erreicht hat, die Beschichtungskammer mit hochreinem Argongas füllen und eine Gleichstromquelle einschalten, um durch den Sputterprozess Feinsilbermaterial auf die Außenfläche des AgMeO-Streifens abzuscheiden und so einen AgMeO/Ag-Streifen zu erhalten, wobei der Vorspannungsstrom 0,01-0,10 *A* beträgt, die Vorspannung 10 bis 100 *V* beträgt und die Dauer 1 bis 30 *h* beträgt; und
③ Herstellen von AgMeO/Ag-Halbfertigspitzen für elektrische Kontakte unter Verwendung des AgMeO/Ag-Streifens durch Stanzen und Ausschneiden sowie Einprägen eines Musters auf die Oberfläche der Silberbeschichtung während des Stanzvorgangs; und nach einer Oberflächenbehandlung der elektrischen Kontakt-Halbfertigspitzen aus AgMeO/Ag Aussortieren von Produkten mit mangelhaftem Aussehen und Abmessungen mittels einer visuellen Sortieranlage, Verpacken der qualifizierten Produkte und automatisches Anbringen von Etiketten, um fertige Kontakte aus AgMeO/Ag zu erhalten.

5. Das Verfahren zur Herstellung von elektrischen Kontaktspitzen aus Silbermetalloxid gemäß Anspruch 1, **dadurch gekennzeichnet, dass** während der Silberbeschichtung durch Magnetron-Sputterverfahren das AgMeO-Substrat erhitzt und auf einer Temperatur von 300-600 °C gehalten wird.

6. Das Verfahren zur Herstellung von elektrischen Kontaktspitzen aus Silbermetalloxid gemäß Anspruch 5, **dadurch gekennzeichnet, dass** während des Aufbringens von Silber durch Magnetron-Sputterverfahren
wenn es sich bei dem AgMeO-Substrat um Silber-Zinn-Oxid handelt, das Silber-Zinn-Oxid-Substrat auf eine Temperatur von 350 bis 450 °C erhitzt und auf dieser Temperatur gehalten wird;
wenn das AgMeO-Substrat aus Silber-Kupferoxid besteht, das Silber-Kupferoxid-Substrat erhitzt und auf einer Temperatur von 300 bis 420 °C gehalten wird;
wenn das AgMeO-Substrat aus Silber-Zinkoxid besteht, das Silber-Zinkoxid-Substrat erhitzt und auf einer Temperatur von 320 bis 460 °C gehalten wird;
wenn das AgMeO-Substrat aus Silber-Eisenoxid besteht, wird das Silber-Eisenoxid-Substrat auf eine Temperatur von 300 bis 450 °C erhitzt und auf dieser Temperatur gehalten;
wenn das AgMeO-Substrat aus Silber-Cadmiumoxid besteht, wird das Silber-Cadmiumoxid-Substrat auf eine Temperatur von 300 bis 400 °C erhitzt und auf dieser Temperatur gehalten; und
wenn das AgMeO-Substrat aus Silber-Zinn-Oxid-Indium-Oxid besteht, wird das Silber-Zinn-Oxid-Indium-Oxid-Substrat auf eine Temperatur von 320 bis 480 °C erhitzt und auf dieser Temperatur gehalten.

7. Das Verfahren zur Herstellung elektrischer Kontaktspitzen aus Silbermetalloxid gemäß Anspruch 6, **dadurch gekennzeichnet, dass** die weiteren Parameter des Magnetron-Sputterprozesses wie folgt sind:
die Sputterleistung beträgt 500 bis 1500 *W*, der Sputtergasdruck beträgt 3,5 bis 4,5 *mTorr*, der Ar-Gasdurchfluss beträgt 25 bis 35 *sccm* und der Abstand zwischen dem Target und dem Substrat beträgt 6 bis 15 *cm*.

## Revendications

1. Un procédé de fabrication de pointes de contact électriques en oxyde métallique d'argent, **caractérisé en ce qu'**il comprend :
le dépôt d'argent sur un substrat d'AgMeO par un procédé de pulvérisation magnétron, l'épaisseur de la couche d'argent déposée étant comprise entre 0,01 *mm* et 0,20 *mm,* l'uniformité de la répartition de la couche d'argent étant de ±0,005 *mm*, et
pendant le dépôt d'argent par procédé de pulvérisation magnétron, le substrat d'AgMeO est chauffé et maintenu à une température comprise entre 30 % et 65 % de son point de fusion,
l'AgMeO étant choisi parmi l'oxyde d'argent-étain, l'oxyde d'argent-cuivre, l'oxyde d'argent-zinc, l'oxyde d'argent-étain-indium, l'oxyde d'argent-cadmium ou l'oxyde d'argent-fer.

2. Le procédé de préparation de pointes de contact électriques en oxyde métallique d'argent selon la revendication 1, **caractérisé en ce que** le substrat AgMeO est rond ou carré, et **en ce que** le procédé comprend les étapes suivantes :
① préparation du fil d'AgMeO : préparation du fil d'AgMeO par un procédé d'oxydation interne classique, un procédé de pré-oxydation ou un procédé de métallurgie des poudres, etc., et traitement du fil d'AgMeO par étirage et recuit jusqu'à l'obtention des spécifications et de l'état requis ;
② formage par frappe à froid : le fil d'AgMeO est transformé en ébauche de pointe en AgMeO à l'aide d'un équipement de frappe à froid, et la surface de soudure de l'ébauche de pointe en AgMeO est marquée d'un motif pendant le formage par frappe à froid ;
③ traitement de surface : l'ébauche de pointe en AgMeO est nettoyée à l'aide d'un équipement de nettoyage par ultrasons afin d'éliminer toute trace d'huile, ce qui permet d'obtenir une ébauche de pointe en AgMeO dont la surface est propre et exempte de tout résidu organique ;
④ placage d'argent par pulvérisation magnétron : disposition de l'ébauche de pointe AgMeO dans un plateau, côté marqué vers le haut, placement du plateau dans un équipement de pulvérisation magnétron, installation d'une cible d'argent fin, mise sous vide préalable de la chambre de placage à ≤ 5 ×10⁻⁴ *Pa* après fermeture de la chambre de dépôt, arrêt de la pompe à vide et de la vanne d'échappement de la chambre de dépôt une fois que le degré de vide de celle-ci a atteint la valeur requise, remplissage de la chambre de dépôt avec de l'argon de haute pureté, puis mise sous tension d'une alimentation en courant continu pour déposer de l'argent fin sur la face du motif de l'ébauche de pointe AgMeO par un procédé de pulvérisation, le courant de polarisation étant compris entre 0,01 et 0,10 *A*, la tension de polarisation est comprise entre 10 et 100 *V*, et la durée est comprise entre 1 et 30 *h* ; et
⑤ contrôle ponctuel et conditionnement : rejeter les produits présentant un aspect ou des dimensions non conformes à l'aide d'un équipement de tri visuel, conditionner les produits conformes et y apposer automatiquement des étiquettes afin d'obtenir des contacts finis en AgMeO/Ag.

3. Le procédé de fabrication de pointes de contact électriques en oxyde métallique d'argent selon la revendication 1, **caractérisé en ce que** le substrat AgMeO est carré ou rectangulaire, et **en ce que** le procédé comprend les étapes suivantes :
① préparation d'une bande d'AgMeO : préparation d'une bande d'AgMeO par un procédé classique d'oxydation interne, un procédé de pré-oxydation ou un procédé de métallurgie des poudres, etc., laminage de la bande d'AgMeO jusqu'à l'épaisseur des produits semi-finis, et élimination des impuretés et des traces d'huile à la surface de la bande d'AgMeO par un traitement de surface ;
② dépôt d'argent par pulvérisation magnétron : enrouler étroitement la bande d'AgMeO sur le cylindre d'un équipement de pulvérisation magnétron, charger le cylindre dans l'équipement de pulvérisation magnétron pour le dépôt d'argent, installer une cible d'argent fin, pré-vider la chambre de dépôt jusqu'à ≤ 5 × 10⁻⁴ *Pa* après fermeture de la chambre de dépôt, arrêter la pompe à vide et la vanne d'échappement de la chambre de dépôt une fois que le degré de vide de la chambre de dépôt a atteint la valeur requise, remplir la chambre de dépôt d'argon de haute pureté, et mettre sous tension une alimentation en courant continu pour déposer de l'argent fin sur la surface externe de la bande d'AgMeO par un procédé de pulvérisation afin d'obtenir une bande d'AgMeO/Ag, le courant de polarisation étant compris entre 0,01 et 0,10 *A*, la tension de polarisation entre 10 et 100 *V*, et la durée comprise entre 1 et 30 *h* ; et
③ découpage de la bande AgMeO/Ag à la largeur des produits semi-finis, puis mise en forme de la bande AgMeO/Ag à la largeur, à l'épaisseur et à la forme des produits finis par laminage profilé ; parallèlement, un motif est imprimé sur la surface de la couche de placage d'argent pendant le laminage profilé ; ensuite, on obtient des embouts semi-finis de contact électrique AgMeO/Ag par découpe et ébarbage selon la longueur requise pour les produits finis ; après traitement de surface des embouts semi-finis de contact électrique en AgMeO/Ag, rejeter les produits présentant un aspect ou des dimensions non conformes à l'aide d'un équipement de tri visuel, emballer les produits conformes et y apposer automatiquement des étiquettes afin d'obtenir des contacts finis en AgMeO/Ag.

4. Le procédé de fabrication de pointes de contact électrique en oxyde métallique d'argent selon la revendication 1, **caractérisé en ce que** la forme du substrat AgMeO est irrégulière, et **en ce que** le procédé comprend les étapes suivantes :
① préparation d'une bande d'AgMeO : préparation d'une bande d'AgMeO par un procédé conventionnel d'oxydation interne, un procédé de pré-oxydation ou un procédé de métallurgie des poudres, etc., laminage de la bande d'AgMeO jusqu'à l'épaisseur des produits semi-finis, et élimination des impuretés et des traces d'huile présentes à la surface de la bande d'AgMeO par traitement de surface ;
② Dépôt d'argent par pulvérisation magnétron : enrouler étroitement la bande d'AgMeO sur le cylindre d'un appareil de pulvérisation magnétron, charger le cylindre dans l'appareil de pulvérisation magnétron pour le dépôt d'argent, installer une cible en argent fin, pré-vider la chambre de dépôt jusqu'à ≤ 5 × 10⁻⁴ *Pa* après avoir fermé la chambre de dépôt, arrêter la pompe à vide et la vanne d'échappement de la chambre de dépôt une fois que le degré de vide de la chambre de dépôt a atteint la valeur requise, remplir la chambre de dépôt d'argon de haute pureté, et mettre sous tension une alimentation en courant continu pour déposer de l'argent fin sur la surface externe de la bande d'AgMeO par un procédé de pulvérisation afin d'obtenir une bande d'AgMeO/Ag, dans laquelle le courant de polarisation est compris entre 0,01 et 0,10 *A*, la tension de polarisation est comprise entre 10 et 100 *V*, et la durée est comprise entre 1 et 30 *h* ; et
③ la préparation de pointes semi-finies de contact électrique AgMeO/Ag à partir de la bande AgMeO/Ag par poinçonnage et découpage, et l'estampage d'un motif sur la surface de la couche de placage d'argent pendant le processus de poinçonnage ; puis, après un traitement de surface des embouts semi-finis de contact électrique AgMeO/Ag, rejeter les produits présentant un aspect ou des dimensions non conformes à l'aide d'un équipement de tri visuel, conditionner les produits conformes et y apposer automatiquement des étiquettes afin d'obtenir des contacts finis en AgMeO/Ag.

5. Le procédé de fabrication de pointes de contact électrique en oxyde métallique d'argent selon la revendication 1, **caractérisé en ce que**, pendant le placage d'argent par un procédé de pulvérisation magnétron, le substrat AgMeO est chauffé et maintenu à une température comprise entre 300 et 600 °C.

6. Le procédé de fabrication d'embouts de contact électrique en oxyde métallique d'argent selon la revendication 5, **caractérisé en ce que**, pendant le dépôt d'argent par pulvérisation cathodique magnétron,
lorsque le substrat AgMeO est de l'oxyde d'argent et d'étain, le substrat d'oxyde d'argent et d'étain est chauffé et maintenu à une température comprise entre 350 et 450 °C ;
lorsque le substrat AgMeO est de l'oxyde d'argent et de cuivre, le substrat d'oxyde d'argent et de cuivre est chauffé et maintenu à une température comprise entre 300 et 420 °C ;
lorsque le substrat AgMeO est de l'oxyde d'argent et de zinc, le substrat d'oxyde d'argent et de zinc est chauffé et maintenu à une température comprise entre 320 et 460 °C ;
lorsque le substrat AgMeO est de l'oxyde d'argent et de fer, le substrat d'oxyde d'argent et de fer est chauffé et maintenu à une température comprise entre 300 et 450 °C ;
lorsque le substrat AgMeO est de l'oxyde d'argent et de cadmium, le substrat d'oxyde d'argent et de cadmium est chauffé et maintenu à une température comprise entre 300 et 400 °C ; et
lorsque le substrat AgMeO est constitué d'oxyde d'argent-étain-indium, le substrat d'oxyde d'argent-étain-indium est chauffé et maintenu à une température comprise entre 320 et 480 °C.

7. Le procédé de préparation de pointes de contact électriques en oxyde métallique d'argent selon la revendication 6, **caractérisé en ce que** les autres paramètres du procédé de pulvérisation magnétron sont les suivants :
la puissance de pulvérisation est comprise entre 500 et 1 500 *W*, la pression du gaz de pulvérisation est comprise entre 3,5 et 4,5 *mTorr*, le débit d'argon est compris entre 25 et 35 *sccm*, et la distance entre la cible et le substrat est comprise entre 6 et 15 *cm*.
